# EUROPÄISCHE PATENTANMELDUNG

(11) **EP 1 182 507 A2**
(43) Veröffentlichungstag der Anmeldung: **27.02.2002**
(21) Anmeldenummer: 01116088.4
(22) Anmeldetag: 03.07.2001
(51) Int. Cl.: G03F 7/20, G02B 17/08

(54) **Projektionsbelichtungsanlage**

(30) Priorität: 22.08.2000 DE 10040998
(71) Anmelder: CARL ZEISS, 89519 Heidenheim (DE); Carl-Zeiss-Stiftung trading as Carl Zeiss, 89519 Heidenheim (DE)
(72) Erfinder: von Bünau, Rudolf, 73457 Essingen (DE); Gaber, Erwin, 89522 Heidenheim (DE); Gruner, Toralf, 73447 Oberkochen (DE)
(74) Vertreter: Ostertag, Ulrich, Dr.

(57) **Zusammenfassung**

Eine Projektionsbelichtungsanlage, insbesondere für die Mikro-Lithographie, weist ein katadioptrisches Projektionsobjektiv (1) und eine Lichtquelle auf. Mindestens ein Spiegel (12) und mindestens eine diesem zugeordnete Linse (8, 9, 10) des Projektionsobjektivs (1) sind aus vorgegebenen Materialien. Diese Vorgabe erfolgt in Abhängigkeit von einer gegebenen Lichtintensitätsverteilung im Projektionsobjektiv (1). Ebenfalls vorgegeben sind die Position des Spiegels (12) und die Position der Linse (8, 9, 10) innerhalb des Projektionsobjektivs. Die Materialauswahl und die Positionsvorgabe erfolgen dabei derart, daß Abbildungsänderungen des Projektionsobjektivs (1), die auf einer beleuchtungsinduzierten Änderung der Reflexionsfläche des Spiegels (12) beruhen, beleuchtungsinduzierten Abbildungsänderungen der Linse (8, 9, 10) entgegenwirken. Beleuchtungsinduzierte Abbildungsänderungen des gesamten Projektionsobjektivs (1) werden auf diese Weise vermindert.

## Beschreibung

Die Erfindung betrifft eine Projektionsbelichtungsanlage, insbesondere für die Mikro-Lithographie, mit einem katadioptrischen Projektionsobjektiv und einer Lichtquelle.

Bei derartigen Projektionsbelichtungsanlagen treten beleuchtungsinduzierte Abbildungsfehler auf, die ihre Ursache in der thermischen Verformung der im Projektionsobjektiv vorliegenden optischen Komponenten haben. Die thermische Verformung resultiert hierbei aus der durch die Restabsorption des Projektionslichts erfolgenden Erwärmung der optischen Komponenten.

Ein weiterer beleuchtungsinduzierter Effekt, der zu Abbildungsfehlern führt, ist die durch das Beleuchtungslicht hervorgerufene Brechzahländerung im durchstrahlten Material der optischen Komponenten. Derartige Brechzahländerungseffekte können reversibel auftreten, so daß die Brechzahl der optischen Komponenten nach der Bestrahlung die gleiche ist wie vorher, oder auch irreversibel sein.

Diese beleuchtungsinduzierten Abbildungsfehler beeinträchtigen die Abbildungsqualität der Projektionsbelichtungsanlage und können insbesondere dort, wo die Auflösung kleinster Strukturen gewünscht ist, nicht hingenommen werden.

Es ist daher die Aufgabe der vorliegenden Erfindung, eine Projektionsbelichtungsanlage der eingangs genannten Art derart weiterzubilden, daß beleuchtungsinduzierte Abbildungsfehler reduziert werden.

Diese Aufgabe wird erfindungsgemäß dadurch gelöst, daß
a) mindestens ein Spiegel und mindestens eine diesem zugeordnete Linse des Projektionsobjektivs aus in Abhängigkeit von einer gegebenen Lichtintensitätsverteilung im Projektionsobjektiv derart gewählten Materialien sind und
b) die Position des Spiegels und die Position der Linse innerhalb des Projektionsobjektivs derart gleichartig sind,
c) daß Abbildungsänderungen des Projektionsobjektivs, die auf einer beleuchtungsinduzierten Abbildungsänderung der Reflexionsfläche des Spiegels beruhen, beleuchtungsinduzierten Abbildungsänderungen der Linse entgegenwirken.

Der Erfindung liegt die Beobachtung zugrunde, daß sich Änderungen des Krümmungsradius von optischen Komponenten, also z. B. eine Verringerung des Krümmungsradius einer konkaven optischen Fläche, bei einer reflektierenden Fläche anders auf die optischen Abbildungseigenschaften dieser Fläche auswirken als bei einer brechenden Fläche.

Insbesondere wirken eine Linse (oder eine Linsengruppe) und ein Spiegel, die an einer gleichartigen Position innerhalb eines Projektionsobjektivs angeordnet sind und entweder beide sammelnde oder beide streuende Wirkung haben, aufgrund der bei ihnen durch die beleuchtungsinduzierte Erwärmung auftretenden Abbildungsänderungen hinsichtlich ihrer Abbildungseigenschaften einander entgegen.
Dies führt zur Möglichkeit, eine Kompensation der beleuchtungsinduzierten Abbildungsänderungen herbeizuführen.

Unter "gleichartiger Position" wird eine derartige positionelle Zuordnung der reflektierenden zur brechenden Fläche, also des Spiegels zu der mindestens einen Linse, verstanden, daß sich die Subaperturverhältnisse in der reflektierenden und in der brechenden Fläche nicht stark unterscheiden. Das Subaperturverhältnis ist hierbei das Verhältnis zwischen dem Abstand zwischen diametral gegenüberliegenden Auftreffpunkten von Randstrahlen, die von einem Feldpunkt, also von einem Punkt des zu projizierenden Objekts, ausgehen, auf der optischen Fläche und der freien Apertur dieser optischen Fläche innerhalb des Projektionsobjektivs.

Bei einem gegebenen Linsendesign eines Projektionsobjektivs ist in der Regel zu einem Spiegel innerhalb des Projektionsobjektivs eine Linse oder eine Linsengruppe angebbar, deren Subaperturverhältnis sich von dem des Spiegels nicht zu stark unterscheidet. Durch eine auf eine Rechnung stützbare Vorgabe der Materialien, aus denen der Spiegel und die Linse bzw. die Linsengruppe zu fertigen sind, ergeben sich insgesamt Abbildungseigenschaften des Projektionsobjektivs, die nur noch in geringem Maße oder gar nicht von beleuchtungsinduzierten Änderungen der Abbildungseigenschaften der einzelnen optischen Komponenten abhängen.

Die Materialauswahl erfolgt hierbei unter Berücksichtigung z. B. der Wärmeleitfähigkeit, des thermischen Ausdehnungskoeffizienten sowie des Brechzahlverhaltens bei einer Temperaturänderung des jeweiligen Materials. Zusätzlich kann noch das Brechzahlverhalten des jeweiligen Materials in Abhängigkeit von der Beleuchtungsintensität berücksichtigt werden.

Derartige kompensierenden Projektionsobjektive sind in hohem Maße unabhängig von beleuchtungsinduzierten Drifts der Abbildungseigenschaften von Einzelkomponenten. Dies erhöht den erzielbaren Durchsatz der Projektionsbelichtungsanlage.

Bevorzugt unterscheiden sich Subaperturverhältnisse des Spiegels und der Linse an ihren jeweiligen Positionen innerhalb des Projektionsobjektivs um weniger als 25 %. Dies stellt sicher, daß die Abbildungsbündel, die einzelnen Objektpunkten zugeordnet sind, in gleicher Weise durch die zugeordneten optischen Flächen beeinflußt werden, so daß eine größtmögliche Kompensation von Abbildungsfehlern, die in den Einzelkomponenten beleuchtungsinduziert werden, erfolgen kann.

Dem Spiegel kann mehr als eine Linse zugeordnet sein. Aufgrund der optischen Verhältnisse bei der Reflexion führen Formänderungen einer reflektierenden Fläche zu größeren Abbildungsänderungen als gleiche Formänderungen einer brechenden Fläche. Daher ist es vorteilhaft, mehrere Linsen zur Kompensation der beleuchtungsinduzierten Abbildungsänderungen eines Spiegels heranzuziehen. Da in bekannten katadioptrischen Projektionsobjektiven die Anzahl der Linsen in der Regel wesentlich größer ist als die Anzahl der reflektierenden Flächen, läßt sich eine derartige Zuordnung in der Regel ohne größere Änderungen des optischen Designs durchführen.

Vorzugsweise sind genau zwei oder genau drei Linsen dem Spiegel zugeordnet. Bei bekannten Designs eines Projektionsobjektivs ist eine Linsengruppe, die bei einem Design aus zwei Einzellinsen und bei einem anderen Design aus drei Einzellinsen besteht, so innerhalb eines Projektionsobjektivs angeordnet, daß sie sich in ihrem Subaperturverhältnis nur sehr gering von demjenigen des Spiegels unterscheidet.

Diese Linsengruppe eignet sich daher besonders gut zur Kompensation beleuchtungsinduzierter Abbildungsänderungen, die durch die Erwärmung der Spiegelfläche hervorgerufen werden. Zudem ist die Linsengruppe bei diesen bekannten Projektionsobjektiven direkt benachbart zum Spiegel angeordnet, so daß sie mit diesem eine einheitliche Baugruppe bilden kann. Dies erleichtert das Nachrüsten der bekannten Projektionsobjektive mit einer im obigen Sinne kompensierenden optischen Baugruppe.

Die Linse kann einen Linsenkörper aus CaF₂ aufweisen. Rechnungen haben gezeigt, daß der Einsatz von Linsen aus diesem Linsenmaterial gemeinsam mit gängigen Materialien, die für Spiegel in katadioptrischen Projektionsobjektiven eingesetzt werden, zu einer guten Abbildungsfehlerkompensation führt.

Der Spiegel kann einen Spiegelträger aus einem der Glasmaterialien BK3, BK6 oder BK7 aufweisen. Diese Materialien sind robust, leicht bearbeitbar und weisen thermische Eigenschaften auf, die sie zum Einsatz als Kompensationselement gut geeignet erscheinen lassen.

Alternativ kann der Spiegelträger aus dem Glasmaterial SK1 aufgebaut sein. Der thermische Ausdehnungskoeffizient von SK1 liegt zwischen BK3 und BK7, so daß sich für bestimmte Anwendungen dieses Material empfiehlt.

Der Spiegel kann bei einer weiteren alternativen Ausführungsform einen Spiegelträger aus einem der Glasmaterialien FK51 oder FK54 aufweisen. Diese Materialien haben einen im Vergleich zu den vorstehend erwähnten Gläsern relativ hohen thermischen Ausdehnungskoeffizienten und bieten daher das Potential für eine große optische Ausgleichswirkung für beleuchtungsinduzierte Abbildungsfehler mindestens eines Spiegels.

Alternativ kann der Spiegel einen Spiegelträger aus dem Glasmaterial Zerodur aufweisen. Zerodur ist ein Glas mit einem extrem geringen thermischen Ausdehnungskoeffizienten, da es aus kristallinen und amorphen Bestandteilen zusammengesetzt ist. Daher sind beleuchtungsinduzierte Effekte, die aus der Erwärmung von Zerodur resultieren, sehr gering. Die beleuchtungsinduzierten Abbildungsänderungen bei einem derartigen Zerodurspiegel sind daher gering und geben z. B. die Möglichkeit, einen Ausgleich mit nur einer Einzellinse vorzunehmen.

Je nach Herstellung läßt sich bei Zerodur ein kleiner thermischer Ausdehungskoeffizient mit positivem oder negativem Vorzeichen erzielen. Bei einem negativen thermischen Ausdehnungskoeffizienten wirkt die auf einer beleuchtungsinduzierten Formänderung eines Spiegels aus diesem Material beruhende Abbildungsänderung additiv zur beleuchtungsinduzierten Änderung der auf einer Formänderung einer zugeordneten Linse beruhenden Abbildungseigenschaften. Dieses Material eignet sich also zum Einsatz in Fällen, in denen Änderungen der Abbildungseigenschaften aufgrund einer beleuchtungsinduzierten Brechzahländerung des Linsenmaterials zu einer Überkompensation der beleuchtungsinduzierten Formänderung der Linse führen. Bei der Linse ergibt sich dadurch ein Nettoeffekt der beleuchtungsinduzierten Abbildungsänderung, der der beleuchtungsinduzierten Abbildungsänderung des Spiegels entgegenwirkt.

Schließlich kann der Spiegel alternativ einen Spiegelträger aus einkristallinem Silizium aufweisen. Auch dieses Material weist einen im Vergleich zu den Gläsern geringen thermischen Ausdehnungskoeffizienten auf. Auch hier ergeben sich nur geringe beleuchtungsinduzierte Abbildungsänderungen des Spiegels.

Die Projektionsbelichtungsanlage kann mit einem konventionellen Beleuchtungssetting betrieben werden. Ein derartiges Beleuchtungssetting, also eine "homogene Füllung" mit Projektionsicht in einer Pupillenebene des Projektionsobjektivs, führt in der Regel zu einer Erwärmung der optischen Komponenten des Projektionsobjektivs, die im Zentrum der beleuchteten Flächen größer ist als am Rand. Dadurch wird der Krümmungsradius beteiligter konvexer optischer Flächen verkleinert und der Krümmungsradius beteiligter konkaver optischer Flächen vergrößert. Rechnungen haben gezeigt, daß derartige Krümmungsradiusänderungen durch eine Kombination eines Spiegels mit einer diesem innerhalb des Projektionsobjektivs zugeordneten Linse oder Linsengruppe gut kompensiert werden können.

Alternativ kann ein kohärentes Beleuchtungssetting eingesetzt werden. Ein derartiges Beleuchtungssetting entspricht einer "homogenen Füllung" mit Beleuchtungslicht nur in einem Zentralbereich einer Pupillenebene des Projektionsobjektivs. Die Änderung der Krümmungsradien der beteiligten optischen Flächen ist daher auf diesen Zentralbereich beschränkt. Ansonsten ergeben sich aber ähnliche Verhältnisse wie beim konventionellen Beleuchtungssetting, so daß ebenfalls eine gute Kompensation möglich ist.

Ein drittes einsetzbares Beleuchtungssetting ist ein annulares Beleuchtungssetting. Dieses ist durch eine "ringförmige Füllung" in einer Pupillenebene des Projektionsobjektivs, bei der ein Zentralbereich nicht beleuchtet wird, gekennzeichnet. Hier ergibt sich in einem ringförmigen Bereich um die optische Achse der optischen Flächen eine Verkleinerung des Krümmungsradius bei konvexen Flächen und eine Vergrößerung des Krümmungsradius bei konkaven Flächen. Auch hier zeigen Rechnungen, daß beleuchtungsinduzierte Abbildungsänderungen, die auf einem Spiegel hervorgerufen werden, durch eine zugeordnete Linse oder Linsengruppe gut kompensiert werden können.

Eine Heizeinrichtung für den Spiegel und/oder die Linse kann zum zusätzlichen Ausgleich der beleuchtungsinduzierten Abbildungsänderungen vorgesehen sein. Durch eine derartige Heizeinrichtung kann eine kompensierende Formgebung einer optischen Fläche innerhalb des Projektionsobjektivs erzeugt werden, die die Kompensation der beleuchtungsinduzierten Abbildungsänderungen noch verbessert. Insgesamt kann so ein Projektionsobjektiv gefertigt werden, daß in seinen Abbildungseigenschaften weitgehend neutral, also unabhängig von der Projektionsbeleuchtung ist.

Die Heizeinrichtung kann eine lichtabsorbierende Beschichtung des Spiegels und/oder der Linse umfassen. In diesem Fall sorgt das Beleuchtungslicht selbst für die geschilderte zusätzliche Kompensationswirkung, indem durch eine über die unvermeidliche Restabsorption hinaus gehende Absorption eine vorgegebene Erwärmung und damit eine vorgegebene Verformung der beschichteten optischen Komponente erfolgt. Die Verformung kann durch die Dicke, den spezifischen Absorptionskoeffizienten und die Position der Beschichtung auf der jeweiligen optischen Fläche beeinflußt werden.

Alternativ oder zusätzlich kann die Heizeinrichtung mindestens ein aktives Heizelement umfassen, das am Umfang der Linse und/oder des Spiegels angeordnet ist. Auf diese Weise kann ein zusätzlicher gezielter Wärmeeintrag in den Linsen- oder Spiegelkörper erfolgen, der eine definierte Formänderung nach sich zieht. Diese kann zur zusätzlichen Kompensation beleuchtungsinduzierter Abbildungsänderungen herangezogen werden.

Die Heizeinrichtung kann mindestens ein aktives Heizelement umfassen, das hinter der Reflexionsfläche des Spiegels am Spiegelträger angeordnet ist. Auf diese Weise läßt sich auch der Zentralbereich einer reflektierenden Fläche erwärmen, wenn dies zu Kompensationszwecken erwünscht ist.

Alternativ oder zusätzlich kann auch eine Kühleinrichtung für den Spiegel und/oder die Linse zum zusätzlichen Ausgleich der beleuchtungsinduzierten Abbildungsänderungen vorgesehen sein. Im Prinzip gilt für die Wirkung der Kühleinrichtung das gleiche, was vorstehend schon zu der Heizeinrichtung ausgeführt wurde. Auch durch Kühlen läßt sich eine definierte Formänderung optischer Flächen erzielen, die zur zusätzlichen Kompensation von beleuchtungsinduzierten Abbildungsänderungen herangezogen werden kann.

Die Kühleinrichtung kann mindestens eine thermische Kontaktfläche zur Ableitung der beleuchtungsinduzierten Erwärmung des Spiegels und/oder der Linse aufweisen. Eine derartige thermische Kontaktfläche kann entweder im Bereich der Umfangsfläche oder bei einem Spiegel auch hinter der Reflexionsfläche des Spiegels am Spiegelträger angeordnet sein. Durch die Wärmeableitung wird eine passive Kühlung der an die thermische Kontaktfläche angrenzenden Bereiche der optischen Komponente erzielt. Auch dies ist zur Kompensation beleuchtungsinduzierter Abbildungsänderungen nutzbar.

Analog zur Heizeinrichtung kann auch die Kühleinrichtung mindestens ein Kühlelement umfassen, das bei einer ersten Ausführungsform am Umfang der Linse und/oder des Spiegels angeordnet ist und bei einer zweiten Ausführungsform alternativ oder zusätzlich hinter der Reflexionsfläche des Spiegels am Spiegelträger angeordnet ist. Hier gilt entsprechend, was oben zur analog ausgeführten Heizeinrichtung erläutert wurde.

Ausführungsbeispiele der Erfindung werden nachfolgend anhand der Zeichnung näher erläutert; es zeigen:
- Figur 1: ein katadioptrisches Projektionsobjektiv für die Mikro-Lithographie;
- Figur 2: Brechungs- bzw. Reflexionsverhältnisse an einer konvexen sphärischen Fläche, deren Krümmungsradius durch eine beleuchtungsinduzierte Erwärmung abnimmt;
- Figur 3: Brechungs- bzw. Reflexionsverhältnisse an einer konkaven sphärischen Fläche, deren Krümmungsradius durch eine beleuchtungsinduzierte Erwärmung zunimmt;
- Figuren 4 bis 6: alternative Beleuchtungssettings für das Projektionsobjektiv von Figur 1.

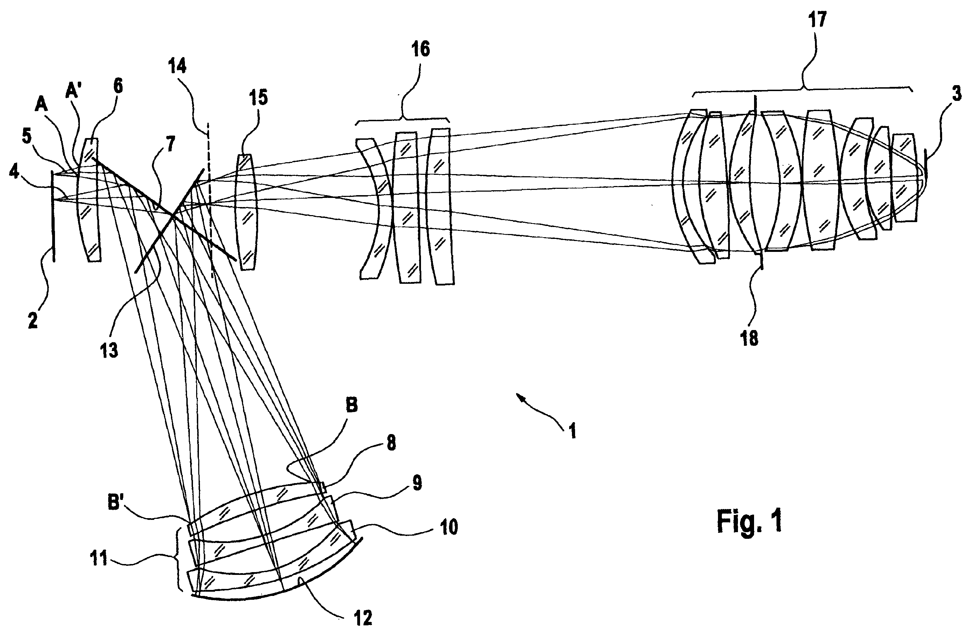

Mit dem in Figur 1 im Meridionalschnitt dargestellten und insgesamt mit dem Bezugszeichen 1 versehenen Projektionsobjektiv wird eine auf einem Retikel 2 befindliche Struktur verkleinert auf einem Wafer 3 abgebildet. Zur Veranschaulichung sind die Strahlengänge von zwei Strahlenbündeln 4, 5, die von zwei Feldpunkten in der Ebene des Retikels 2 ausgehen, durch das Projektionsobjektiv 1 dargestellt. Die Strahlenbündel 4, 5 sind vom Retikel 2 transmittiertes Licht einer Projektionslichtquelle, z.B. eines ArF-Excimerlasers mit einer Wellenlänge von 193,3 nm, der in der Zeichnung nicht dargestellt ist.

Anhand des Durchgangs der Strahlenbündel 4, 5 durch das Projektionsobjektivs 1 wird nun dessen Aufbau erläutert:

Die vom Retikel 2 ausgehenden Strahlenbündel 4, 5 treten zunächst durch eine dem Retikel 2 benachbarte Linse 6 mit positiver Brechkraft. Die Randstrahlen des Strahlenbündels 5 treten durch die Eintrittsfläche der Linse 6 an Punkten A, A' ein. Der Abstand zwischen den Punkten A und A' ist klein im Verhältnis zur freien Apertur der Linse 6.

Anschließend werden die Strahlenbündel 4, 5 von einer planen Spiegelfläche 7 in der Zeichenebene in einem stumpfen Winkel in Richtung einer aus drei Einzellinsen 8, 9, 10 bestehenden Linsengruppe 11 reflektiert. Die Randstrahlen des Strahlenbündels 5 durchtreten die Eintrittsfläche der Linse 8 an Punkten B, B'. Der Abstand zwischen den Punkten B, B' ist hierbei näherungsweise gleich der freien Apertur der Linsen 8, 9, 10.

Das Verhältnis zwischen dem Abstand A, A' bzw. B, B', also dem Abstand zwischen den Auftreffpunkten der Randstrahlen, die von einem Feldpunkt des Retikels 2 ausgehen, auf einer optischen Komponente und der freien Apertur dieser optischen Komponente wird im Folgenden Subaperturverhältnis genannt.

Die Strahlenbündel 4, 5 treffen nach einem ersten Durchgang durch die Linsengruppe 11 auf einen Konkavspiegel 12. Dieser weist eine Reflexionsschicht auf, die von einem nicht dargestellten Tragkörper getragen wird. Die Brechkraft der Linse 6 und der Linsengruppe 11 ist so, daß der Konkavspiegel 12 in einer Pupillenebene des Projektionsobjektivs 1 liegt. Das Subaperturverhältnis ist bei den Linsen 8, 9, 10 der Linsengruppe 11 sowie beim Konkavspiegel 12 näherungsweise gleich 1, da diese optischen Komponenten in bzw. in der Nähe einer Pupillenebene liegen. Das zu einem Feldpunkt gehörende Strahlenbündel 4, 5, nimmt also praktisch die gesamte freie Apertur dieser optischen Komponenten ein.

Nach der Reflexion am Konkavspiegel 12 durchtreten die Strahlenbündel 4, 5 in einem zweiten Durchlauf die Linsengruppe 11. Die Strahlenbündel 4, 5, die nach der Reflexion am Konkavspiegel 12 in die Nähe der Spiegelfläche 7 zurückkehren, werden von einer weiteren Spiegelfläche 13 um einen spitzen Winkel in der Zeichenebene reflektiert.

Im Strahlengang nach der Spiegelfläche 13 weist das Projektionsobjektiv 1 eine dieser benachbarte Zwischenbildebene 14 auf. Nach der Zwischenbildebene 14 durchtreten die Strahlenbündel 4, 5 eine Einzellinse 15 sowie zwei weitere Linsengruppen 16, 17, deren Aufbau im Detail hier nicht weiter interessiert. In der Linsengruppe 17 durchsetzen die Strahlenbündel 4, 5 eine weitere Pupillenebene 18. Durch die Linsengruppe 17 werden die Strahlenbündel 4, 5 auf den Wafer 3 abgebildet.

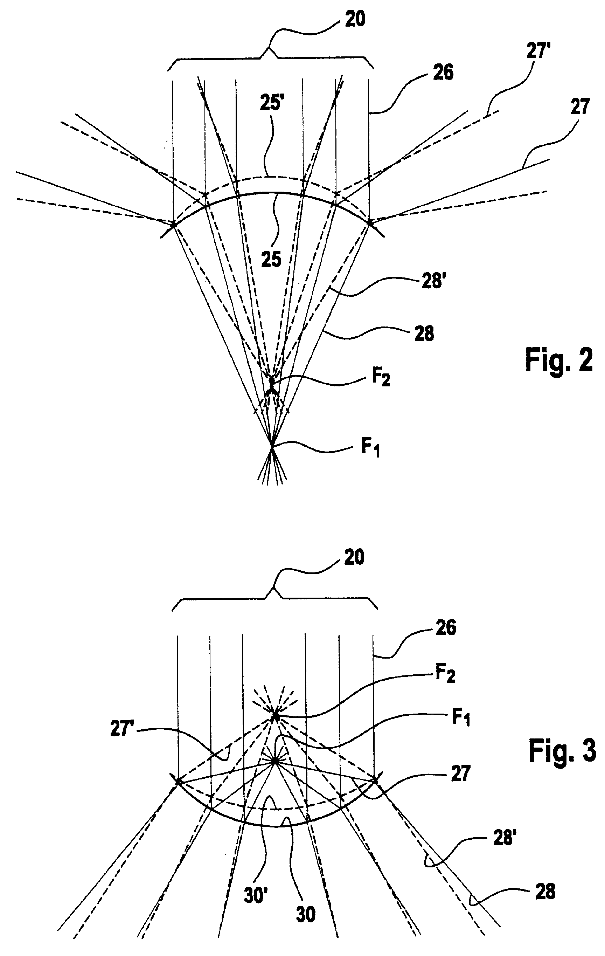

Die Abbildungsverhältnisse bei einer konvexen brechenden bzw. reflektierenden Fläche, die sich infolge der bei der Beleuchtung auftretenden Restabsorption erwärmt und dadurch ausdehnt, zeigt Figur 2. Derartige Restabsorptionen können z.B. im Linsenkörper, im Bereich einer von einem Trägerkörper getragenen Reflexionsschicht eines Spiegels oder in dessen Trägerkörper selbst erfolgen.

Bei der Beschreibung der Abbildungsverhältnisse der Figuren 2 und 3, die jeweils Meridionalschnitte einer reflektierenden bzw. brechenden Fläche zeigen, werden Öffnungsfehler vernachlässigt. Die bei Erwärmung auftretende Änderung des Krümmungsradius der optischen Fläche ist zudem, verglichen mit dem realen Fall, stark übertrieben.

In Fig. 2 trifft das Beleuchtungs-Strahlenbündel 20, von dem in Figur 2 sechs Einzelstrahlen 26 dargestellt sind, von oben auf eine konvex gekrümmte reflektierende bzw. brechende Fläche 25. Im Folgenden wird zunächst angenommen, daß es sich bei der Fläche 25 um eine reflektierende Fläche handelt. Dann werden die sechs Einzelstrahlen 26 von der Fläche 25 derart reflektiert, daß das Beleuchtungs-Strahlenbündel zerstreut wird. Die von der Fläche 25 reflektierten und durchgezogen dargestellten Einzelstrahlen sind mit dem Bezugszeichen 27 bezeichnet. Die reflektierende Fläche 25 wirkt also als zerstreuender Spiegel mit einer vorgegebenen negativen Brennweite.

Wenn sich die reflektierende Fläche 25 aufgrund von Restabsorption des einfallenden Beleuchtungs-Strahlenbündels 20 erwärmt, wird der zentrale Flächenbereich der Fläche 25, der den Kern des Beleuchtungs-Strahlenbündels 20 reflektiert, am stärksten erwärmt, da hier die Wärme nicht in seitlicher Richtung, also quer zum Strahlengang, abgeführt werden kann. Dies führt dazu, daß sich der Trägerkörper (nicht dargestellt) der Fläche 25 in diesem zentralen Flächenbereich am stärksten in Richtung der optischen Achse der optischen Komponente, zu der die Fläche 25 gehört, ausdehnt. Insgesamt resultiert eine Fläche 25', deren Krümmungsradius kleiner ist als derjenige der "kalten" Fläche 25. Die erwärmte Fläche 25' ist in Figur 2 gestrichelt dargestellt.

Dieser kleinere Krümmungsradius führt dazu, daß die von der erwärmten Fläche 25' reflektierten Einzelstrahlen 27', die in Figur 2 gestrichelt dargestellt sind, an der erwärmten Fläche 25' stärker gestreut werden, als dies bei der kalten Fläche 25 der Fall war. Insgesamt wirkt also die erwärmte Fläche 25' als stärker streuender Spiegel als die kalte Fläche 25.

Zusätzlich sind in Figur 2 die Verhältnisse bei einer Lichtbrechung an der Fläche 25 dargestellt. Hierbei wird vorausgesetzt, daß die Einzelstrahlen 26 beim Durchgang durch die Fläche 25 in ein optisch dichteres Medium eintreten. Die konvexe brechende Fläche 25 wirkt somit als Sammelfläche, die im "kalten Zustand" durchgezogen dargestellte Einzelstrahlen 28 des Beleuchtungs-Strahlenbündels 20 in einen Brennpunkt F₁ fokussiert.

Wie oben schon ausgeführt, hat die erwärmte Fläche 25' einen kleineren Krümmungsradius als die kalte Fläche 25. Die Brechkraft der erwärmten Fläche 25' ist daher größer als diejenige der kalten Fläche 25, so daß die an der erwärmten Fläche 25' gebrochenen Einzelstrahlen 28' (gestrichelt dargestellt) sich in einem Brennpunkt F₂ vereinigen, dessen Abstand zur Eintrittsfläche geringer ist als der Abstand des Brennpunkts F₁ zur Eintrittsfläche. Die erwärmte brechende Fläche 25' stellt daher eine Sammelfläche kürzerer Brennweite dar als die kalte Fläche 25.

In Figur 3 sind in zur Figur 2 analoger Darstellung die Abbildungsverhältnisse bei einer konkav gekrümmten reflektierenden bzw. brechenden Fläche 30 dargestellt.

Unter der Voraussetzung, daß die Fläche 30 als reflektierende Fläche wirkt, also im Falle des Spiegels 12 von Fig. 1, werden die einfallenden Einzelstrahlen 26 des Beleuchtungs-Strahlenbündels 20 als Einzelstrahlen 27 reflektiert und vereinigen sich in einem Brennpunkt F₁.

Auf Grund der Bestrahlung der Fläche 30 mit dem einfallenden Beleuchtungs-Strahlenbündel 20 erfolgt eine Erwärmung durch Restabsorption. Diese führt analog zum im Zusammenhang mit der Figur 2 Ausgeführten zu einem Anheben der Fläche 30, das im zentralen Bereich der Fläche 30 am stärksten ist. Die erwärmte Fläche ist mit 30' bezeichnet. Sie hat einen größeren Krümmungsradius als die nicht erwärmte Fläche 30. Dies führt dazu, daß von der erwärmten Fläche. 30' reflektierte Einzelstrahlen 27' sich in einem Brennpunkt F₂ sammeln, der von der Sammelfläche einen größeren Abstand hat als der Brennpunkt F₁ von der kalten Fläche 30. Die konkave Fläche 30' wirkt also durch die Erwärmung als Sammelspiegel mit größerer Brennweite.

Ebenfalls in Figur 3 ist, analog zur Figur 2, die Wirkung einer sich erwärmenden konkaven brechenden Fläche 30 gezeigt. Auch hier sind die "kalt" gebrochenen Einzelstrahlen mit 28 und die "warm" gebrochenen Einzelstrahlen mit 28' bezeichnet. Durch die Zunahme des Krümmungsradius wirkt die Fläche 30 bei der Erwärmung als schwächere Zerstreuungslinse verglichen mit der Zerstreuungswirkung im kalten Zustand.

Eine Kombination aus einer brechenden konvexen Fläche 25 (vgl. Figur 2) mit einer reflektierenden konkaven Fläche 30 (vgl. Figur 3), die vom Strahlengang nacheinander durchlaufen werden, verhält sich bei der Erwärmung wie folgt:

Im kalten Zustand haben die brechende Fläche 25 und die reflektierende Fläche 30 jeweils eine durch eine Brennweite spezifizierte Sammelwirkung. Wie oben dargestellt, nimmt die Sammelwirkung der Fläche 25 mit der Erwärmung zu und die Sammelwirkung des Spiegels 30 mit der Erwärmung ab. Es ist daher möglich, durch geeignete Auswahl der Materialien des Trägers der brechenden Fläche 25, also eines Linsenkörpers, und des Trägerkörpers für die Spiegelfläche 30 sowie durch eine geeignete Vorgabe der Ausgangsbrennweiten der Flächen 25 und 30, des Abstands dieser beiden optischen Komponenten sowie weiterer Parameter (s. u.) ein Abbildungsverhalten zu erzielen, bei dem sich die durch die Erwärmung bedingten Abbildungsänderungen gerade ausgleichen.

Beim Projektionsobjektiv 1, das im Zusammenhang mit der Figur 1 beschrieben wurde, dienen die drei Linsen 8, 9, 10 der Linsengruppe 11 als optische Kompensationselemente für das Erwärmungsverhalten des Spiegels 12.

Der Konkavspiegel 12 weist dabei eine Reflexionsschicht auf, die auf einem Spiegelträger aus dem Glasmaterial BK7 aufgetragen ist. Alternativ kann der Spiegelträger auch aus dem Glasmaterial Zerodur gefertigt sein. Die Linsen 8, 9, 10 sind aus Kalziumfluorid (CaF₂).

Die Restabsorptionen in den Linsenkörpern bzw. in der Reflexionsschicht des Konkavspiegels 12 sind bei der Wellenlänge von 193,3 nm im Promillebereich.

Bei einer typischen Erwärmung der Linsen 8, 9, 10 und des Konkavspiegels 12 durch das Beleuchtungs-Strahlenbündel 20 wurden für unterschiedliche Beleuchtungssettings folgende Änderungen der Zernikekoeffizienten der Wellenfrontdeformation (in nm) berechnet. Diese Berechnung erfolgte unter der Annahme einer Beleuchtungswellenlänge von 157 nm. Die Ergebnisse sind in der nachfolgenden Tabelle dargestellt:

| | Konventionelles Setting | | Annulares Setting | | Kohärentes Setting | |
|---|---|---|---|---|---|---|
| Zernikekoeffizient der Wellenfrontdeformation (in nm) | Spiegel 12 | Linsen 8-10 | Spiegel 12 | Linsen 8-10 | Spiegel 12 | Linsen 8-10 |
| Z4 | -35,5 | 22,4 | -27,5 | 7,2 | -33,5 | 7,2 |
| Z9 | 3,1 | -5,7 | -3,7 | 3,2 | -5,5 | 5,1 |
| Z17 | 1,4 | -2,2 | -1,1 | 1,8 | 6,6 | -10,0 |

Den Zernikekoeffizienten der Wellenfrontdeformation lassen sich verschiedene Bildfehler zuordnen. Einer Bildfeldwölbung entspricht ein in bestimmter Form über das Feld variierender Wert von Z4. Ein konstanter Wert für Z4 entspricht einer Defokussierung. Z17 entspricht der Vierwelligkeit.

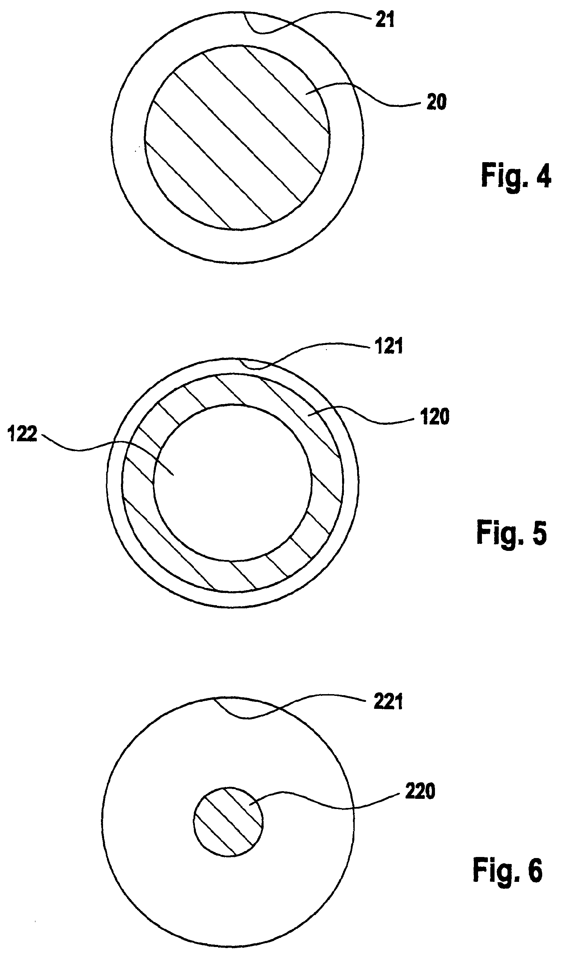

Die in der Tabelle aufgeführten Beleuchtungssettings bezeichnen verschiedene Projektionslichtverteilungen in der Pupillenebene, die z.B. durch eine entsprechende Blende in einer Pupillenebene in einer im Strahlengang vor dem Retikel 2 liegenden Beleuchtungsoptik für die Lichtquelle der Projektionsbelichtungsanlage (nicht dargestellt) erzeugt werden können. Drei Beispiele derartiger Beleuchtungssettings sind in den Figuren 4 bis 6 gezeigt. Hierbei ist jeweils ein schematischer Schnitt senkrecht zur optischen Achse der Projektionsbelichtungsanlage 1 in einer Pupillenebene dargestellt.

In Figur 4 ist ein sog. konventionelles Beleuchtungssetting gezeigt, bei dem ein homogenes Beleuchtungs-Strahlenbündel 20 in der dargestellten Pupillenebene einen Querschnitt mit kreisförmiger Begrenzung aufweist. Das Beleuchtungs-Strahlenbündel 20 liegt dabei koaxial in der freien Apertur 21 der Optik des Projektionsobjektivs 1 derart, daß das Verhältnis zwischen der numerischen Apertur des Beleuchtungs-Strahlenbündels 20 und der durch die freie Apertur 21 vorgegebenen numerischen Apertur der Optik des Projektionsobjektivs 1 ungefähr bei 0,5 liegt.

Bei dem in der Figur 5 gezeigten sog. annularen Beleuchtungssetting ist ein Beleuchtungs-Strahlenbündel 120 in der dargestellten Pupillenebene ringförmig, so daß in der Pupillenebene eine zentrale unbeleuchtete Mittenregion 122 vorliegt. Das Verhältnis der durch den äußeren Rand des Beleuchtungs-Strahlenbündels 20 vorgegebenen numerischen Apertur der Beleuchtung und der durch die freie Apertur 121 vorgegebenen numerischen Apertur der Optik des Projektionsobjektivs 1 liegt bei diesem Beleuchtungssetting typischerweise zwischen 0,5 und 0,8.

Auch beim in der Figur 6 dargestellten sog. kohärenten Beleuchtungssetting liegt ein homogenes Beleuchtungs-Strahlenbündel 220 vor, welches einen Querschnitt mit kreisförmiger Begrenzung aufweist. Im Verhältnis zur freien Apertur 221 der Optik des Projektionsobjektivs weist das Beleuchtungs-Strahlenbündel 20 jedoch einen wesentlich geringeren Durchmesser auf als das Beleuchtungs-Strahlenbündel 20 von Figur 4, so daß beim kohärenten Beleuchtungssetting der Figur 6 das oben beschriebene Verhältnis der numerischen Aperturen bei typischerweise 0,3 liegt.

Aus der Tabelle ist ersichtlich, daß sich die Änderungen der durch den Spiegel hervorgerufenen Wellenfrontdeformation durch die von den Linsen 8 bis 10 bewirkten Änderungen zumindest teilweise ausgleichen lassen. Die vom Spiegel und von den Linsen bewirkten Änderungen haben immer entgegengesetztes Vorzeichen, so daß der Absolutbetrag der Abbildungsänderung im Gesamtsystem aus Spiegeln und Linsen immer kleiner ist als der Absolutwert des maximalen Einzelbeitrags.

Die Änderungen der Zernikekoeffizienten wurden wie folgt berechnet: Zunächst wurde aus dem jeweils vorgegebenen Beleuchtungssetting und aus der Beugungscharakteristik eines Retikels eine ortsabhängige Beleuchtungswinkelverteilung bei der Beleuchtung jeder zu betrachtenden einzelnen optischen Komponente (8, 9, 10, 12) bestimmt. Anschließend wurden die Strahlungsenergieverteilungen auf den einzelnen optischen Komponenten (8, 9, 10, 12) berechnet. Daraus wurde die in den einzelnen optischen Komponenten (8, 9, 10, 12) absorbierte Strahlungsenergie bestimmt. Mit einer Finite-Elemente-Methode wurden anschließend die Temperaturverteilung und die Materialdeformation der einzelnen optischen Komponenten (8, 9, 10, 12) berechnet. Hieraus wurden die Bildfehlerbeiträge (d.h. die Änderungen der Zernikekoeffizienten) auf Grund der thermisch induzierten Brechzahländerungen und der Materialdeformation für jede der einzelnen optischen Komponenten (8, 9, 10, 12) berechnet.

Analog wirkt auch die Kombination einer reflektierenden konvexen Fläche 25 (vgl. Figur 2) und einer brechenden konkaven Fläche 30 (vgl. Figur 3), die vom Strahlengang nacheinander durchlaufen werden. Die reflektierende konvexe Fläche 25 streut bei Erwärmung stärker, wie im Zusammenhang mit Figur 2 ausgeführt. Dies kann durch eine Abnahme des Betrags der Brennweite der reflektierenden Fläche 25, z.B. von f = -100 mm zu f = -99 mm spezifiziert werden. Gleichzeitig führt die Erwärmung einer konkaven brechenden Fläche 30 dazu, daß ihre Streuwirkung schwächer wird. Hierbei könnte sich z.B. eine Brennweitenänderung von f = -100 mm zu f = -101 mm ergeben. Auch hier ist ersichtlich, daß sich aufgrund der entgegengesetzt wirkenden Änderungen der Brennweiten einer derartigen Kombination optischer Flächen eine Kombination zugehöriger optischer Komponenten angeben läßt, deren optische Gesamtabbildungsverhältnisse unabhängig von einer beleuchtungsinduzierten Änderung der optischen Eigenschaften einer Einzelkomponente sind.

Ursache für eine Änderung der Brechkraft einer Linse kann neben der thermischen Ausdehnung, wie oben erläutert, auch eine Änderung des Brechungsindex sein. Diese kann den beschriebenen Ausdehnungseffekt verstärken oder diesem entgegenwirken. Letztlich bleibt ein resultierender Effekt übrig, also bei einer konvexen Linsenfläche eine Zunahme oder, wenn der Brechungsindexeffekt gegenläufig ist und den Ausdehnungseffekt überwiegt, sogar eine Abnahme der Brechkraft bei Erwärmung. Je nach Größe und Richtung des Effekts ist jedoch immer gemäß dem vorstehend Ausgeführten eine Kombination einer derartigen Linse mit einem Spiegel mit einem Spiegelträger aus einem Material mit einem positven oder einem negativen thermischen Ausdehnungskoeffizienten möglich, bei der die Abbildungsänderungen sich gerade gegenseitig aufheben.

Neben BK7 sind z.B. folgende weitere Materialien für den Spiegelträger einsetzbar:

| Material | Thermischer Ausdehnungskoeffizient (α in µm/[m K] ) |
|---|---|
| Zerodur | -0,1 bis 0,1 |
| Silizium | 0,5 |
| BK3 | 6,1 |
| SK1 | 7,1 |
| BK7 | 8,3 |
| BK6 | 9,1 |
| FK51 | 15,3 |
| FK54 | 16,5 |

Daneben können auch andere Materialien mit entsprechendem thermischem Verhalten, z.B. spezielle Kohlenstoffverbindungen, als Spiegelträgermaterialien dienen.

Als sich in der oben beschriebenen Weise kompensierend verhaltende optische Komponenten müssen nicht notwendigerweise direkt benachbarte Komponenten dienen. Es genügt für die Ausgleichswirkung, wenn sich die optischen Komponenten an Positionen befinden, an denen sie sich nicht zu stark unterscheidende Subaperturverhältnisse aufweisen. Rechnungen haben gezeigt, daß ein Unterschied im Subaperturverhältnis von 25% noch zu einer guten Ausgleichswirkung führt.

Beim Projektionsobjektiv 1 der Figur 1 haben beispielsweise die optischen Komponenten 8 bis 12 sowie die optischen Komponenten der Linsengruppe 17, die sich alle in der Nähe einer Pupillenebene des Projektionsobjektivs 1 befinden, alle ein Subaperturverhältnis nahe 1. Diese Komponenten sind somit optisch gleichwertig positioniert und können als Kompensationselemente eingesetzt werden. Es ist daher z. B. möglich, optische Erwärmungseffekte, die beim Spiegel 12 auftreten, durch eine oder alle Linsen der Linsengruppe 17 auszugleichen.

Zusätzlich kann auf die beleuchtungsinduzierte Erwärmung der einander zugeordneten optischen Komponenten noch durch andere Parameter Einfluß genommen werden. Als Beispiele hierfür seien eine zusätzliche gezielte Erwärmung von optischen Komponenten oder Bereichen von diesen durch angebrachte Heizelemente oder durch Beschichtungen, die nicht benötigtes Projektionslicht absorbieren, eine gezielte Kühlung von optischen Komponenten oder eine gezielte passive Wärmeableitung genannt.

Heiz-, Kühl- oder Wärmeableitelemente, die an eine reflektierende Fläche angekoppelt werden, können sowohl im Umfangsbereich der Fläche als auch hinter der Reflexionsfläche, also an der der bestrahlten Seite gegenüberliegenden Seite der Reflexionsfläche, angeordnet sein.

Eine Ankopplung von Heiz-, Kühl- oder Wärmeableitelementen erfolgt bei transmissiven Elementen in der Regel im Umfangsbereich, um Projektionslichtverluste zu vermeiden.

Durch diese Ausgleichsparameter kann ein thermisch induzierter Resteffekt auf die optischen Abbildungseigenschaften, der nach der vorstehend beschriebenen Wirkung der beleuchtungsinduzierten Formänderungen von Linsen und Spiegeln noch verbleibt, vollends kompensiert werden.

## Patentansprüche

1. Projektionsbelichtungsanlage, insbesondere für die Mikro-Lithographie, mit einem katadioptrischen Projektionsobjektiv und einer Lichtquelle,
**dadurch gekennzeichnet, daß**
a) mindestens ein Spiegel (12) und mindestens eine diesem zugeordnete Linse (8, 9, 10) des Projektionsobjektivs (1) aus in Abhängigkeit von einer gegebenen Lichtintensitätsverteilung im Projektionsobjektiv (1) derart gewählten Materialien sind und
b) die Position des Spiegels (12) und die Position der Linse (8, 9, 10) innerhalb des Projektionsobjektivs (1) derart gleichartig sind,
c) daß Abbildungsänderungen des Projektionsobjektivs (1), die auf einer beleuchtungsinduzierten Abbildungsänderung der Reflexionsfläche des Spiegels (12) beruhen, beleuchtungsinduzierten Abbildungsänderungen der Linse (8, 9, 10) entgegenwirken.

2. Projektionsbelichtungsanlage nach Anspruch 1, **dadurch gekennzeichnet, daß** sich die Subaperturverhältnisse des Spiegels (12) und der Linse (8, 9, 10) an ihren jeweiligen Positionen innerhalb des Projektionsobjektivs (1) um weniger als 25% unterscheiden.

3. Projektionsbelichtungsanlage nach Anspruch 1 oder 2, **dadurch gekennzeichnet, daß** mehr als eine Linse (8, 9, 10) dem Spiegel (12) zugeordnet ist.

4. Projektionsbelichtungsanlage nach Anspruch 3, **dadurch gekennzeichnet, daß** genau drei Linsen (8, 9, 10) dem Spiegel (12) zugeordnet sind.

5. Projektionsbelichtungsanlage nach Anspruch 3, **dadurch gekennzeichnet, daß** genau drei Linsen (8, 9, 10) dem Spiegel (12) zugeordnet sind.

6. Projektionsbelichtungsanlage nach einem der vorhergehenden Ansprüche, **dadurch gekennzeichnet, daß** der Spiegel und die ihm zugeordneten Linsen eine Gruppe optischer Komponenten bilden, wobei die Linsen innerhalb der Gruppe derart ausgewählt und angeordnet sind, daß die Abbildungsänderungen der Linsen innerhalb der Gruppe die Abbildungsänerungen des Spiegels kompensieren.

7. Projektionsbelichtungsanlage nach einem der vorhergehenden Ansprüche, **dadurch gekennzeichnet, daß** die Linse (8, 9, 10) einen Linsenkörper aus CaF₂ aufweist.

8. Projektionsbelichtungsanlage nach einem der vorhergehenden Ansprüche, **dadurch gekennzeichnet, daß** der Spiegel (12) einen Spiegelträger aus einem der Glasmaterialien BK3, BK6 oder BK7 aufweist.

9. Projektionsbelichtungsanlage nach einem der Ansprüche 1 bis 7, **dadurch gekennzeichnet, daß** der Spiegel (12) einen Spiegelträger aus dem Glasmaterial SK1 aufweist.

10. Projektionsbelichtungsanlage nach einem der Ansprüche 1 bis 7, **dadurch gekennzeichnet, daß** der Spiegel (12) einen Spiegelträger aus einem der Glasmaterialien FK51 oder FK54 aufweist.

11. Projektionsbelichtungsanlage nach einem der Ansprüche 1 bis 7, **dadurch gekennzeichnet, daß** der Spiegel (12) einen Spiegelträger aus dem Glasmaterial Zerodur aufweist.

12. Projektionsbelichtungsanlage nach einem der Ansprüche 1 bis 7, **dadurch gekennzeichnet, daß** der Spiegel (12) einen Spiegelträger aus einkristallinem Silizium aufweist.

13. Projektionsbelichtungsanlage nach einem der vorhergehenden Ansprüche, **gekennzeichnet durch** ein konventionelles Beleuchtungssetting.

14. Projektionsbelichtungsanlage nach einem der Ansprüche 1 bis 13, **gekennzeichnet durch** ein kohärentes Beleuchtungssetting.

15. Projektionsbelichtungsanlage nach einem der Ansprüche 1 bis 13, **gekennzeichnet durch** ein annulares Beleuchtungssetting.

16. Projektionsbelichtungsanlage nach einem der vorhergehenden Ansprüche, **gekennzeichnet durch** eine Heizeinrichtung für den Spiegel (12) und/oder die Linse (8, 9, 10) zum zusätzlichen Ausgleich der beleuchtungsinduzierten Abbildungsänderungen.

17. Projektionsbelichtungsanlage nach Anspruch 16, **dadurch gekennzeichnet, daß** die Heizeinrichtung eine lichtabsorbierende Beschichtung des Spiegels (12) und/oder der Linse (8, 9, 10) umfaßt.

18. Projektionsbelichtungsanlage nach Anspruch 16 oder 17, **dadurch gekennzeichnet, daß** die Heizeinrichtung mindestens ein aktives Heizelement umfaßt, das am Umfang der Linse und/oder des Spiegels (12) angeordnet ist.

19. Projektionsbelichtungsanlage nach einem der Ansprüche 16 bis 18, **dadurch gekennzeichnet, daß** die Heizeinrichtung mindestens ein aktives Heizelement umfaßt, das hinter der Reflexionsfläche des Spiegels (12) am Spiegelträger angeordnet ist.

20. Projektionsbelichtungsanlage nach einem der vorhergehenden Ansprüche, **gekennzeichnet durch** eine Kühleinrichtung für den Spiegel (12) und/oder die Linse (8, 9, 10) zum zusätzlichen Ausgleich der beleuchtungsinduzierten Abbildungsänderungen.

21. Projektionsbelichtungsanlage nach Anspruch 20, **dadurch gekennzeichnet, daß** die Kühleinrichtung mindestens eine thermische Kontaktfläche zur Ableitung der beleuchtungsinduzierten Erwärmung des Spiegels (12) und/ oder der Linse (8, 9, 10) aufweist.

22. Projektionsbelichtungsanlage nach Anspruch 20 oder 21, **dadurch gekennzeichnet, daß** die Kühleinrichtung mindestens ein aktives Kühlelement umfaßt, das am Umfang der Linse und/oder des Spiegels (12) angeordnet ist.

23. Projektionsbelichtungsanlage nach einem der Ansprüche 20 bis 22, **dadurch gekennzeichnet, daß** die Kühleinrichtung mindestens ein aktives Kühlelement umfaßt, das hinter der Reflexionsfläche des Spiegels (12) am Spiegelträger angeordnet ist.
